# EUROPÄISCHE PATENTSCHRIFT

(11) **EP 2 415 021 B1**
(45) Veröffentlichungstag und Bekanntmachung des Hinweises auf die Patenterteilung: **27.07.2016**
(21) Anmeldenummer: 10718508.4
(22) Anmeldetag: 06.04.2010
(51) Int. Cl.: G06T 7/00

(54) **VERFAHREN UND VORRICHTUNG FÜR DIE AUSRICHTUNG VON SUBSTRATEN**
METHOD AND DEVICE FOR ALIGNING SUBSTRATES
PROCÉDÉ ET DISPOSITIF D'ALIGNEMENT DE SUBSTRATS

(30) Priorität: 03.04.2009 DE 102009016288
(43) Veröffentlichungstag der Anmeldung: 08.02.2012
(73) Patentinhaber: Singulus Technologies AG, 63796 Kahl am Main (DE)
(72) Erfinder: RÜTH, Edgar, 63796 Kahl am Main (DE); BECKER, Wolfgang, 64850 Schaafheim (DE); FILIPOVIC, Marjan, 63667 Nidda (DE); ROHRMANN, Reiner, 63579 Freigericht (DE)
(74) Vertreter: Vossius & Partner Patentanwälte Rechtsanwälte mbB
(86) Internationale Anmeldenummer: PCT/EP2010/054501
(87) Internationale Veröffentlichungsnummer: WO 2010/112613

(56) Entgegenhaltungen:
- WO-A1-00/26640
- WO-A1-99/60610
- US-B1- 6 366 310

## Beschreibung

Die vorliegende Erfindung betrifft ein Verfahren und eine Vorrichtung für die Ausrichtung und den Transport von Substraten und insbesondere ein Verfahren und eine Vorrichtung bei der ein beliebig parallel zur X-Y-Ebene ausgerichtetes Substrat durch Referenzkoordinaten und eine Referenzwinkellage in der X-Y-Ebene ausgerichtet wird, wobei während des Transports zusätzlich eine Kanteninspektion durchgeführt werden kann.

Das Aufnehmen von Substraten aus vorgelagerten Maschinen und/oder Anlagen und das Ablegen der Substrate auf den nachfolgenden Maschinen oder Anlagen ist eine Standardaufgabe in der Produktionstechnik. Dabei ist es von großer Bedeutung die Substrate auf den nachfolgenden Maschinen positionsgenau und lagerichtig ausgerichtet abzulegen. Dies erfordert eine Ausrichtung der Substrate. Die Ausrichtung eines quadratischen Substrats kann dadurch erreicht werden, dass das Substrat mit einer seiner Seitenflächen bündig an einem Substrataufnehmer anliegt. D.h. der Substrataufnehmer muss mindestens eine Kante des Substrats berühren. Im Fall von nicht quadratischen bzw. bei mehreckigen Substraten lässt sich durch den Kontakt des Substrataufnehmers mit einer Seite des Substrats eine exakte Ausrichtung nicht erzielen. Es muss eine Überprüfung durchgeführt werden, welche Seite des Substrats mit dem Substrataufnehmer in Kontakt steht. Soll zusätzlich eine Qualitätskontrolle der Substrate, d.h. eine Kanteninspektion erfolgen, dann muss das Substrat in einem weiteren Prozessschritt abgelegt werden, so dass alle Kanten für eine Überprüfung frei zugänglich sind.

Für einen möglichst effektiven Ablauf sind solche zusätzlichen Prozessschritte unerwünscht. Ein weiterer Nachteil, der sich aus dem Stand der Technik ergibt, besteht darin, dass die empfindlichen Kanten durch den Substrataufnehmer berührt werden. Eine Beschädigung der Kanten des zerbrechlichen Substrats ist dadurch leicht möglich.

Die WO 99/60610 beschreibt eine Substrathandhabungsvorrichtung mit einem Transferarm, der einen Substratträger aufweist, wobei die Vorrichtung mindestens eine Bildaufnahme aufweist, mit der Bilder eines durch den Substratträger getragenen Substrats aufgenommen werden können.

Die WO 00/26640 beschreibt eine Bestückungsvorrichtung und deren Abbildungssystem, wobei das Abbildungssystem mit einem Kopf der Bestückungsvorrichtung bewegbar ist und einen linearen Detektor aufweist, der geeignet ist, sich in die Nähe einer Komponente zu bewegen und dabei die Komponente abzutasten.

Die US-B-6, 366,310 beschreibt ein Montagegerät für elektronische Teile zum teilweisen Erkennen eines elektronischen Teils, auch wenn die Vorrichtung derart angeordnet ist, dass die relative örtliche Beziehung zwischen einer Erkennungskamera und einer Düse nicht geändert werden kann.

Im Hinblick auf die vorstehend erwähnten Probleme des Stands der Technik ist es Aufgabe der vorliegenden Erfindung, ein Verfahren und eine Vorrichtung für die Ausrichtung von Substraten bereitzustellen, wobei die Substrate durch den Substrataufnehmer nicht an der Seite gehalten bzw. berührt werden und trotzdem positionsgenau und lagerichtig ausgerichtet abgelegt werden. Bereits während des Transports soll die Möglichkeit einer Qualitätskontrolle bestehen, wodurch zusätzliche Prozessschritte entfallen. Diese und weitere Aufgaben werden durch die Merkmale der Patentansprüche gelöst.

Dabei geht die Erfindung von folgendem Grundgedanken aus: Ein mehreckiges, flächiges, parallel zu einer X-Y-Ebene liegendes Substrat wird bezüglich der Differenz der Positionskoordinaten zu den Referenzkoordinaten und der Differenz der Winkellage zur Referenzwinkellage der Ecke des Substrats in der X-Y-Ebene verschoben und/oder verdreht. Durch mehrmaliges Drehen des Substrats um eine Achse senkrecht zur Substratebene kann zusätzlich eine Überprüfung weiterer oder aller Substratkanten und Substratecken während des Substrattransports erfolgen.

Durch einen Substrataufnehmer (z.B. einen Sauger) kann ein mehreckiges, flächiges (vorzugsweise quadratisches) Substrat in der Mitte gehalten (angesaugt) werden. Der Substrataufnehmer ist vorzugsweise in XYZ-Richtung bewegbar und zusätzlich um die Z-Achse d.h. senkrecht zur Substratebene oder X-Y-Ebene drehbar. Durch eine Bilderfassungseinrichtung wird eine Ecke des Substrats erfasst. Danach werden die Positionskoordinaten und die Winkellage der Ecke des Substrats ermittelt. Mit Hilfe einer Auswerteeinrichtung können die Positionsdifferenzen zwischen den Referenzkoordinaten und den Positionskoordinaten sowie die Winkeldifferenz zwischen der Referenzwinkellage und der Winkellage der Substratecke bestimmt werden. Mit der Kenntnis der Positionsdifferenz und der Winkeldifferenz kann eine entsprechende Verschiebung und/oder Rotation des Substrataufnehmers erfolgen, so dass das Substrat positionsgenau und lagerichtig ausgerichtet abgelegt werden kann. Eine Beschädigung der Substratkanten kann vermieden werden, da die Substratkanten nicht berührt werden. Das Substrat kann mehrmals um eine Achse senkrecht zur Substratoberfläche gedreht werden. Dadurch werden alle Ecken und Kanten des Substrats mit der Bilderfassungseinrichtung erfasst. Mit Hilfe der Auswerteeinrichtung kann aus den gewonnen Daten eine Überprüfung der Ecken und Kanten vorgenommen werden. Ein zusätzlicher Prozessschritt (wie z. B. das Ablegen oder das erneute Aufnehmen des Substrats) ist nicht erforderlich. Durch diese Kanteninspektion können unbrauchbare oder beschädigte Substrate aussortiert werden.

Vor der Aufnahme oder nach der Ablage des Substrats mit dem Substrataufnehmer kann zusätzlich eine kostengünstige Eingangskontrolle durchgeführt werden. Hierbei werden die Substrate mit Hilfe einer Beleuchtung von unten beleuchtet. Eine Zeilenkamera kann über das durchscheinende Licht Haarrisse und defekte Stellen auf dem Substrat erkennen.

Die Erfindung ist insbesondere auch für den Photovoltaikbereich geeignet, d.h. bei der Bearbeitung und Handhabung sogenannter PV-Substrate (PV = Photovoltaik).

Die Erfindung wird nachstehend mit Bezug auf die Zeichnungen näher erläutert. Es zeigen:
Fig. 1 eine schematische Darstellung eines in XYZ-Richtung bewegbaren und zusätzlich um die Z-Achse drehbaren erfindungsgemäßen Substrataufnehmer;
Fig. 2a eine schematische Darstellung des Bilderfassungsbereichs einer Bilderfassungseinrichtung von einem Substrat in der Draufsicht; und
Fig. 2b eine Schnittansicht entlang der gestrichelten Linie in Fig. 2a.

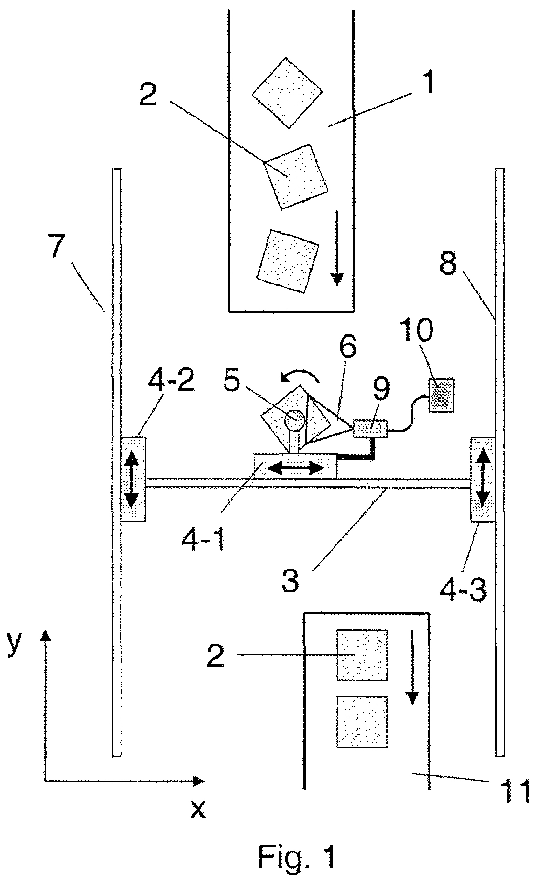

Fig. 1 zeigt eine erfindungsgemäße Vorrichtung zum Transport und zum lagerichtigen Positionieren eines Substrats 2. Das Substrat 2 wird aus einer vorgelagerten nicht dargestellten Maschine bzw. Anlage auf einem Förderband 1 abgelegt. Das Förderband bewegt sich in Richtung des Pfeils in Fig. 1. Anschließend wird das Substrat 2 lagerichtig und positionsgenau auf einem weiteren Förderband 11 abgelegt. Dieses Förderband 11 transportiert das Substrat 2 in Pfeilrichtung zu einer nachfolgenden (ebenfalls nicht dargestellten) Maschine bzw. Anlage. Durch das erste Förderband 1 wird eine X-Y-Ebene definiert. Das Substrat 2 liegt willkürlich ausgerichtet in der X-Y-Ebene auf dem in Pfeilrichtung bewegten Förderband 1. Im Folgenden wird auch jede zu dieser Ebene parallele Ebene mit X-Y-Ebene bezeichnet. Das mehreckige, flächige Substrat 2 kann, wie in Fig. 1 dargestellt, quadratisch sein. Dabei kann es sich um ein Substrat aus Silizium mit z.B. einer Seitenlänge von 156 mm und einer Dicke von 150 µm handeln.

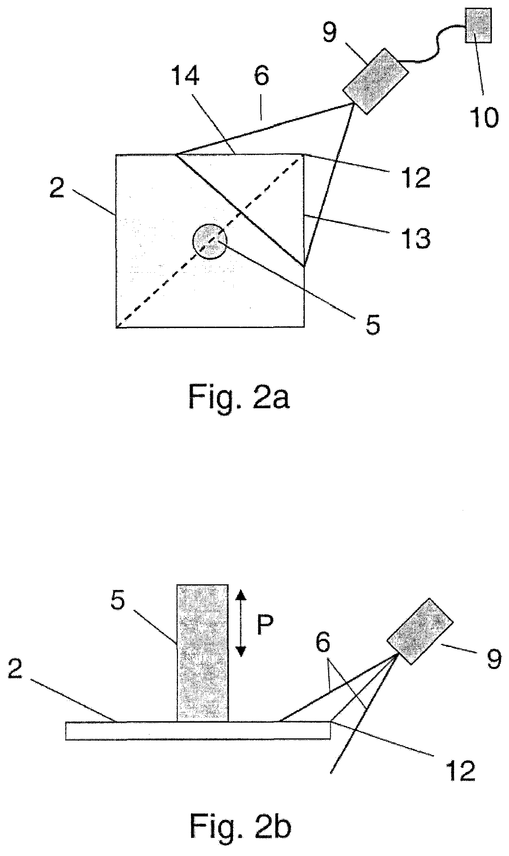

Das Substrat 2 wird mit einem z.B. auf- und abbewegbaren (vgl. den Doppelpfeil P in Fig. 2 b) Substrataufnehmer 5 von dem Förderband 1 aufgenommen, wobei die empfindlichen Substratkanten nicht berührt werden. Das Substrat 2 wird bevorzugt in der Mitte aufgenommen. Der Substrataufnehmer 5 kann als Sauger ausgebildet sein. Der Substrataufnehmer 5 ist mit einem auf einer Schiene 3 in der X-Y-Ebene in X-Richtung bewegbaren Schlitten 4-1 verbunden. Die Schiene 3 wird über zwei weitere Schlitten 4-2 und 4-3 entlang der Schiene 7 bzw. der Schiene 8 in Y-Richtung bewegt. Damit kann der Substrataufnehmer 5 mit Hilfe der beweglichen Schlitten 4-1, 4-2 und 4-3 mit Servomotoren (nicht dargestellt) in X- und Y-Richtung verfahren werden. Zusätzlich kann der Substrataufnehmer 5 durch einen weiteren Servomotor in Z-Richtung, d.h. senkrecht zur Zeichenebene bewegt werden (die Möglichkeit der Bewegung in Z-Richtung ist in Fig. 1 ebenfalls nicht dargestellt). Dabei können die Servomotoren direkt an den Schlitten 4-1, 4-2 und 4-3 montiert werden. Es ist jedoch ebenfalls möglich, die Servomotoren ortsfest zu installieren und eine geeignete Kraftübertragung (z.B. über einen Ketten- oder Zahnriemenantrieb) von den Servomotoren auf die Schlitten zu wählen. Mit einem weiteren nicht dargestellten Servomotor erfolgt eine Drehung des Substrataufnehmers 5 um seine Mittelachse. Dadurch ist der Substrataufnehmer 5 in der Lage, mit dem aufgenommenen Substrat 2 während des Substrattransports in XYZ-Richtung eine Drehbewegung in der X-Y-Ebene auszuführen.

Die Figuren 2a und 2b zeigen das durch den Substrataufnehmer 5 aufgenommene Substrat 2. Dabei zeigt Fig. 2a eine Draufsicht von oben auf das Substrat 2, das von dem Substrataufnehmer 5 gehalten wird. Der Bilderfassungsbereich 6 einer Bilderfassungseinrichtung 9 wird durch den Abstand des Substrats 2 von der Bilderfassungseinrichtung 6 und den Winkel, mit dem die Bilderfassungseinrichtung 9 aufnimmt, bestimmt. Fig. 2b zeigt einen Schnitt durch das Substrat 2 und den Substrataufnehmer 5 entlang der gestrichelten Linie in Fig. 2a. Gemäß Fig. 2b erfasst die Bilderfassungseinrichtung 9 eine Ecke 12 und die angrenzenden beiden Kanten 13, 14 des Substrats 2 von schräg oben. Die Bilderfassungseinrichtung 9 kann mit dem Schlitten 4-1 verbunden sein, wie dies in Fig. 1 schematisch angedeutet ist (in Fig. 2a und 2b ist der Schlitten 4-1 nicht gezeigt). Dabei kann die Bilderfassungseinrichtung eine Kamera 9, die am Schlitten 4-1 befestigt ist, und eine Datenverarbeitungseinrichtung 10 aufweisen. Die Datenverarbeitungseinrichtung 10 kann, wie in Fig. 1 gezeigt, mit einem Kabel oder über eine Funkverbindung mit der Kamera 9 verbunden sein. Alternativ kann die Datenverarbeitungseinrichtung 10 auch in der Kamera 9 integriert sein. Mit Hilfe der Kamera 9 wird die Ecke 12 des Substrats 2 erfasst, die sich in dem Bilderfassungsbereich 6 der Kamera 9 befindet. Die Daten der Bilderfassungseinrichtung 9 werden an eine Auswerteeinrichtung 10 übermittelt. Mit Hilfe der Auswerteeinrichtung 10 wird die Winkellage dieser Ecke 12 und der angrenzenden beiden Kanten 13, 14 des Substrats in der X-Y-Ebene ermittelt. Im Anschluss wird die Winkeldifferenz zwischen der Referenzwinkellage (d.h. der gewünschten Ausrichtung des Substrats 2 in der X-Y-Ebene am Ablagepunkt) und der Winkellage der Substratecke 12 berechnet. Zusätzlich werden die Positionskoordinaten des Substrats 2 mit einer Positionskoordinatenerfassungseinrichtung erfasst. Die Auswerteeinrichtung 10 berechnet ebenfalls die Positionsdifferenzen zwischen den Referenzkoordinaten (gewünschte Position des Substrats bei der Ablage) und den Positionskoordinaten. Aus der Positionsdifferenz und der Winkeldifferenz kann mit Hilfe der XYZ-Positionierung und der Drehung des Substrataufnehmers 5 der positionsgenaue Transport zum Ablagepunkt und die lagerichtige Ausrichtung des Substrats 2 erfolgen. Dabei erfolgt die Rotationsausrichtung des Substrats 2 während des Substrattransports.

Bei der oben beschriebenen Methode wird das Substrat 2 mit dem Substrataufnehmer 5 aufgenommen, wobei alle Kanten des Substrats 2 berührungsfrei bleiben. Der große Vorteil ist, dass die zerbrechlichen Kanten somit nicht beschädigt werden können.

Erfindungsgemäß können die notwendigen Bildbearbeitungszeiten sowie die Verfahr-Reaktionszeiten kurz gehalten werden. Die Zeit von der Aufnahme des Substrats 2 bis zum Ablegen des richtig positionierten Substrats 2 kann bei einem ca. 1 m entfernten Ablagepunkt im Bereich von 350 bis 500 ms liegen.

Erfindungsgemäß kann während des Transports und/oder während der Ausrichtung des Substrats gleichzeitig eine Kanteninspektion durchgeführt werden. Wie oben beschrieben, wird das Substrat 2 mit dem Substrataufnehmer 5 aufgenommen, und die Ecke 12 und große Abschnitte der angrenzenden beiden Kanten 13, 14 des Substrats 2, die sich im Bilderfassungsbereich 6 der Kamera 9 befinden, erfasst. Nach der ersten Bildaufnahme der Bilderfassungseinrichtung 9 wird das mehreckige, flächige Substrat 2 in der X-Y-Ebene soweit um eine Achse senkrecht zur Substratebene (X-Y-Ebene) gedreht, bis sich die nächste Ecke im Bilderfassungsbereich 6 befindet. Dann wird diese Ecke 12 und große Abschnitte der beiden angrenzenden Kanten 13, 14 erfasst. Dabei muss sichergestellt sein, dass die Kante zwischen den beiden erfassten Ecken 12 ebenfalls vollständig erfasst wird. Dazu muss sich der Bilderfassungsbereich 6 bei der Aufnahme der ersten Ecke 12 mit dem Bilderfassungsbereich 6 bei der Aufnahme der nachfolgenden Ecke 12 überlappen. Das Drehen des Substrats 2 und das Erfassen der Ecke 12 und der angrenzenden Kanten 13, 14 wird solange wiederholt, bis alle Ecken und Kanten des Substrats erfasst sind. Im Falle eines quadratischen Substrats 2 ergibt sich nach drei Drehungen um 90° um die Achse senkrecht zur Substratebene eine komplette Aufnahme der Substratkante. Die aufgenommenen Daten werden an die Auswerteeinrichtung 10 übermittelt. Mit dem Auswerteergebnis lassen sich Defekte an der Substratkante erkennen und anzeigen. Diese Substrate 2 können z.B. als defekte Substrate 2 aussortiert werden. Im Anschluss an die Qualitätskontrolle erfolgt die Ausrichtung und Ablage der Substrate. Vorteilhaft ist dabei, dass schon während des Transportvorgangs eine Qualitätskontrolle der Substrate 2 stattfindet. Bei dieser kostengünstigen und zeitsparenden Qualitätskontrolle wird sichergestellt, dass die empfindlichen Kanten der Substrate 2 nicht berührt und somit auch nicht beschädigt werden. Das zusätzliche Anfahren einer separaten Prüfposition entfällt.

Zusätzlich zu der oben beschriebenen Überprüfung der Substratkanten 13, 14 kann eine kostengünstige Eingangskontrolle für die kompletten Substrate 2 durchgeführt werden. Eine Eingangskontrolle für die kompletten Substrate kann z.B. an einer Position zwischen zwei Förderbändern, d.h. zwischen zwei Transportbändern, Linearförderern, Drehtischen usw. erfolgen. Dabei leuchtet eine Beleuchtung von unten zwischen den beiden Förderbändern hindurch auf die Substrate. Mit einer Zeilenkamera wird das durchscheinende Licht oberhalb des Förderbandes erfasst. Damit können Haarrisse und defekte Stellen auf dem Substrat 2 erkannt werden. Substrate können damit kostengünstig auf Vorschädigungen untersucht und gegebenenfalls aussortiert werden.

## Patentansprüche

1. Verfahren zum Ausrichten eines mehreckigen, flächigen Substrats (2) in einer X-Y-Ebene, dessen Substratebene zur X-Y-Ebene parallel ist oder in dieser liegt, bezüglich Referenzkoordinaten und einer Referenzwinkellage in der X-Y-Ebene während des Substrattransports, durch:
a) Bilderfassen einer Ecke (12) des Substrats (2) und der an der Ecke angrenzenden Substratkanten (13, 14),
b) Ermitteln der Positionskoordinaten und Auswerten der erfassten Bildinformationen zum Ermitteln der Winkellage der Ecke (12) des Substrats (2) in der X-Y-Ebene,
c) Berechnen der Positionsdifferenzen zwischen Referenzkoordinaten und Positionskoordinaten sowie der Winkeldifferenz zwischen der Referenzwinkellage und der Winkellage der Substratecke (12), und
d) Ausrichten des Substrats (2) durch Verschieben und/oder Verdrehen des Substrats (2) in der X-Y-Ebene entsprechend der ermittelten Positionsdifferenz bzw. der Winkeldifferenz, wobei während des Substrattransports und/oder während des Ausrichtens des Substrats eine Kanteninspektion durchgeführt wird durch die Schritte:
e) Auswerten der erfassten Bildinformationen bezüglich der Qualität der Substratecke (12) und der an der Ecke angrenzenden Substratkanten (13, 14),
f) Drehen des Substrats (2) zu einer anderen Ecke (12) um eine Achse senkrecht zur Substratebene und
g) Wiederholen der Schritte a) und e).

2. Verfahren nach Anspruch 1 mit der Wiederholung der Schritte f) und g) für alle Ecken während des Substrattransports.

3. Verfahren nach Anspruch 1 oder 2, wobei das Substrat (2) mit nicht ausreichender Qualität einer Substratkante (13, 14) oder Substratecke (12) aussortiert wird.

4. Verfahren nach einem der Ansprüche 1 bis 3, wobei das Substrat (2) zum Verschieben, Verdrehen und/oder zum Transport ohne Berührung der Substratkanten aufgenommen wird.

5. Verfahren nach einem der Ansprüche 1 bis 4, wobei das Substrat (2) rechteckig, vorzugsweise quadratisch ist.

6. Verfahren nach Anspruch 5, wobei das Substrat (2) eine Seitenlänge von 100 bis 160 mm, vorzugsweise von 156 mm, und/oder eine Dicke von 50 bis 250 µm, bevorzugt von 130 bis 170 µm, vorzugsweise von 150 µm, aufweist.

7. Verfahren nach einem der Ansprüche 1 bis 6, wobei das Substrat (2) Silizium aufweist.

8. Verfahren nach einem der Ansprüche 1 bis 7, mit einer Eingangskontrolle für das komplette Substrat (2) vor oder nach dem Ausrichten des Substrats zur Feststellung von Vorschädigungen.

9. Vorrichtung zum Ausrichten eines mehreckigen, flächigen Substrats (2) in einer X-Y-Ebene, dessen Substratebene zur X-Y-Ebene parallel ist oder in dieser liegt, bezüglich Referenzkoordinaten und einer Referenzwinkellage in der X-Y-Ebene während des Substrattransports, eingerichtet zur Durchführung des Verfahrens nach einem der Ansprüche 1 bis 8, mit:
a) einer Bilderfassungseinrichtung (9) zum Erfassen einer Ecke (12) des Substrats (2) und der an der Ecke angrenzenden Substratkanten (13, 14),
b) einer Einrichtung zum Erfassen der Positionskoordinaten des Substrats (2),
c) einer Auswerteeinrichtung (10) zum Auswerten der Informationen der Bilderfassungseinrichtung (9) bezüglich der Qualität der Substratecke (12) und der angrenzenden Substratkanten (13, 14) und zum Ermitteln der Winkellage der Ecke (12) des Substrats (2) in der X-Y-Ebene und zum Berechnen der Positionsdifferenzen zwischen den Referenzkoordinaten und den Positionskoordinaten sowie der Winkeldifferenz zwischen der Referenzwinkellage und der Winkellage der Substratecke (12), und
d) einer Einrichtung zum Drehen des Substrats (2) zu einer anderen Ecke (12) um eine Achse senkrecht zur Substratebene und zum Verschieben und/oder Verdrehen des Substrats (2) in der X-Y-Ebene entsprechend der ermittelten Positionsdifferenz bzw. der Winkeldifferenz.

10. Vorrichtung nach Anspruch 9, mit einer Einrichtung zum Aussortieren eines Substrats (2) mit nicht ausreichender Qualität einer Substratkante (13, 14) oder Substratecke (12).

11. Vorrichtung nach einem der Ansprüche 9 oder 10, mit einem Substrataufnehmer (5), der das Substrat (2) ohne Berührung der Substratkanten aufnimmt.

12. Vorrichtung nach einem der Ansprüche 9 bis 11, wobei das Substrat (2) rechteckig, vorzugsweise quadratisch ist.

13. Vorrichtung nach einem der Ansprüche 9 bis 12, mit einer Einrichtung zur Durchführung einer zusätzlichen Kontrolle, bei der das komplette Substrat (2) auf Vorschädigungen untersucht wird.

14. Anwendung des Verfahrens nach einem der Ansprüche 1 bis 8 und/oder Verwendung der Vorrichtung nach einem der Ansprüche 9 bis 13 bei der Bearbeitung oder Herstellung von Photovoltaik-Substraten.

## Claims

1. A method for aligning a polygonal, flat substrate (2) in an XY-plane, the plane of the substrate being parallel to the XY-plane or lying therein, with respect to reference coordinates and a reference angular position in the XY-plane during substrate transport by:
(a) detecting an image of a corner (12) of the substrate (2) and the substrate edges (13, 14) adjacent the corner;
(b) determining the position coordinates and evaluating the detected image information for determining the angular position of the corner (12) of the substrate (2) in the XY-plane,
(c) calculating the position differences between reference coordinates and position coordinates as well as the angle difference between the reference angular position and the angular position of the substrate corner (12), and
(d) aligning the substrate (2) by moving and/or rotating the substrate (2) in the XY-plane in accordance with the detected position difference or angle difference,
wherein during substrate transport and/or during aligning the substrate, an edge inspection is carried out by the steps:
(e) evaluating the detected image information with respect to the quality of the substrate corner (12) and the substrate edges (13, 14) adjoining the corner,
(f) rotating the substrate (2) towards another corner (12) about an axis extending perpendicular with respect to the substrate plane and
(g) repeating steps (a) and (e).

2. The method according to claim 1, comprising a repetition of steps (f) and (g) for all corners during substrate transport.

3. The method according to claim 1 or 2, wherein the substrate (2) with insufficient quality of a substrate edge (13, 14) or substrate corner (12) is sorted out.

4. The method according to any one of claims 1 to 3, wherein the substrate (2) is picked-up without contacting the substrate edges for moving, rotating and/or transporting.

5. The method according to any one of claims 1 to 4, wherein the substrate (2) is rectangular, preferably square.

6. The method according to claim 5, wherein the substrate (2) has a side length of 100 to 160 mm, preferably 156 mm, and/or a thickness of 50 to 250 µm, preferably 130 to 170 µm, preferably 150 µm.

7. The method according to any one of claims 1 to 6, wherein the substrate (2) comprises silicon.

8. The method according to any one of claims 1 to 7, comprising a reception control of the complete substrate (2) before or after aligning the substrate in order to detect previous damage.

9. A device for aligning a polygonal, flat substrate (2) in an XY-plane, the plane of the substrate being parallel to the XY-plane or lying therein, with respect to reference coordinates and a reference angular position in the XY-plane during substrate transport, adapted for carrying out the method according to any one of claims 1 to 8, comprising:
(a) image detecting means (9) for detecting a corner (12) of the substrate (2) and the substrate edges (13, 14) adjoining the corner,
(b) means for detecting the position coordinates of the substrate (2),
(c) evaluating means (10) for evaluating the information of the image detecting means (9) with respect to the quality of the substrate corner (12) and the adjoining substrate edges (13, 14) and for detecting the angular position of the corner (12) of the substrate (2) in the XY-plane and for calculating the position differences between the reference coordinates and the position coordinates as well as the angle difference between the reference angular position and the angular position of the substrate corner (12), and
(d) means for rotating the substrate (2) to another corner (12) about an axis extending perpendicular with respect to the substrate plane and for moving and/or rotating the substrate (2) in the XY-plane in accordance with the detected position difference or angle difference.

10. The device according to claim 9, comprising means for sorting out a substrate (2) with insufficient quality of a substrate edge (13, 14) or substrate corner (12).

11. The device according to any one of claim 9 or 10, comprising a substrate pick-up (5) which picks up the substrate (2) without contacting the substrate edges.

12. The device according to any one of claims 9 to 11, wherein the substrate (2) is rectangular, preferably square.

13. The device according to any one of claims 9 to 12, comprising means for carrying out an additional control in which the complete substrate (2) is inspected in view of previous damage.

14. Use of the method according to any one of claims 1 to 8 and/or use of the device according to any one of claims 9 to 13 for processing or producing photovoltaic substrates.

## Revendications

1. Procédé d'alignement d'un substrat (2) plat polygonal dans un plan X-Y, dont le plan de substrat est parallèle au plan X-Y ou coïncide avec celui-ci, relativement à des coordonnées de référence et à une position angulaire de référence dans le plan X-Y pendant le transport du substrat, par :
a) enregistrement d'image d'un coin (12) du substrat (2) et des bords de substrat (13, 14) adjacents au coin,
b) détection des coordonnées de position et évaluation des informations d'image enregistrées, en vue de déterminer la position angulaire du coin (12) du substrat (2) dans le plan X-Y,
c) calcul des différences de position entre coordonnées de référence et coordonnées de position, et de la différence angulaire entre la position angulaire de référence et la position angulaire du coin de substrat (12), et
d) alignement du substrat (2) par translation et/ou rotation du substrat (2) dans le plan X-Y en fonction de la différence de position ou de la différence angulaire déterminée, une inspection de bord étant effectuée pendant le transport du substrat et/ou pendant l' alignement du substrat, comprenant les étapes suivantes :
e) évaluation des informations d'image enregistrées relativement à la qualité du coin de substrat (12) et des bords de substrat (13, 14) adjacents au coin,
f) rotation du substrat (2) vers un autre coin (12), autour d'un axe perpendiculaire au plan de substrat, et
g) répétition des étapes a) et e).

2. Procédé selon la revendication 1 avec répétition des étapes f) et g) pour tous les coins pendant le transport du substrat.

3. Procédé selon la revendication 1 ou la revendication 2, où le substrat (2) dont la qualité d'un bord de substrat (13, 14) ou d'un coin de substrat (12) est insuffisante, est rejeté.

4. Procédé selon l'une des revendications 1 à 3, où le substrat (2) est reçu sans contact des bords de substrat pour la translation, la rotation et/ou pour le transport.

5. Procédé selon l'une des revendications 1 à 4, où le substrat (2) est rectangulaire, préférentiellement carré.

6. Procédé selon la revendication 5, où le substrat (2) présente une longueur de côté comprise entre 100 et 160 mm, préférentiellement égale à 156 mm, et/ou une épaisseur de 50 à 250 µm, préférentiellement comprise entre 130 et 170 µm, préférentiellement égale à 150 µm.

7. Procédé selon l'une des revendications 1 à 6, où le substrat (2) comprend du silicium.

8. Procédé selon l'une des revendications 1 à 7, avec un contrôle d'entrée pour la totalité du substrat (2) avant ou après l'alignement du substrat, pour le constat de dommages préalables.

9. Dispositif pour l'alignement d'un substrat (2) plat polygonal dans un plan X-Y, dont le plan de substrat est parallèle au plan X-Y ou coïncide avec celui-ci, relativement à des coordonnées de référence et à une position angulaire de référence dans le plan X-Y pendant le transport du substrat, prévu pour l'exécution du procédé selon l'une des revendications 1 à 8, avec :
a) un dispositif d'enregistrement d'image (9) pour l'enregistrement d'un coin (12) du substrat (2) et des bords de substrat (13, 14) adjacents au coin,
b) un dispositif de détection des coordonnées de position du substrat (2),
c) un dispositif d'évaluation (10) pour l'évaluation des informations du dispositif d'enregistrement d'image (9) relativement à la qualité du coin de substrat (12) et des bords de substrat (13, 14) adjacents, pour la détermination de la position angulaire du coin (12) du substrat (2) dans le plan X-Y et pour le calcul des différences de position entre les coordonnées de référence et les coordonnées de position, et de la différence angulaire entre la position angulaire de référence et la position angulaire du coin de substrat (12), et
d) un dispositif de rotation du substrat (2) vers un autre coin (12) autour d'un axe perpendiculaire au plan de substrat et pour la translation et/ou la rotation du substrat (2) dans le plan X-Y en fonction de la différence de position ou de différence angulaire déterminée.

10. Dispositif selon la revendication 9, comportant un dispositif pour le rejet d'un substrat (2) dont la qualité d'un bord de substrat (13, 14) ou d'un coin de substrat (12) est insuffisante.

11. Dispositif selon la revendication 9 ou la revendication 10, comportant un récepteur de substrat (5) recevant le substrat (2) sans contact des bords de substrat.

12. Dispositif selon l'une des revendications 9 à 11, où le substrat (2) est rectangulaire, préférentiellement carré.

13. Dispositif selon l'une des revendications 9 à 12, comportant un dispositif pour l'exécution d'un contrôle supplémentaire, où la totalité du substrat (2) est examinée quant à la présence de dommages préalables.

14. Application du procédé selon l'une des revendications 1 à 8 et/ou utilisation du dispositif selon l'une des revendications 9 à 13 lors du traitement ou de la fabrication de substrats photovoltaïques.
